# EUROPEAN PATENT APPLICATION

(11) **EP 4 718 100 A1**
(43) Date of publication of application: **01.04.2026**
(21) Application number: 24203688.7
(22) Date of filing: 30.09.2024
(51) Int. Cl.: G01R 33/26, G01R 33/32, G01R 33/385, G01R 33/44, G01N 24/10, G01R 33/60, G01R 33/02

(54) **METHOD AND APPARATUS FOR INCREASING A SIGNAL FROM PROBE SPINS SENSING PRECESSING SAMPLE SPINS**

(71) Applicant: Technische Universität München, in Vertretung des Freistaats Bayern, 80333 München (DE)
(72) Inventor: Bruckmaier, Fleming Paul, 80337 München (DE); Von Grafenstein, Nick Ruben, 80339 München (DE); Bucher, Dominik Benjamin, 82178 Puchheim (DE)
(74) Representative: Lucke, Andreas

(57) **Abstract**

A method is provided for increasing a measurand, said measurand being associated with the exposure of probe spins to a sample magnetic field generated by precessing sample spins. The method comprises providing a solid comprising spin systems localized therein, said spin systems providing the probe spins, said probe spins having an average position. The method comprises providing a sample in a sample region, the sample comprising said sample spins, and said sample having a sample average position. The method comprises applying a static magnetic field to the sample region, the static magnetic field having a component being spatially homogeneous in the sample region, said component acting along a first direction, said static magnetic field causing the sample spins to precess. A distance between the sample average position and the average position of the probe spins does not exceed one millimeter, such that the probe spins are exposed to a sample magnetic field generated by the precessing sample spins. The method comprises, while the static magnetic field is being applied to the sample region: applying a pulsed magnetic field to the sample region, the pulsed magnetic field having a component along the first direction, wherein a gradient of said component of the pulsed magnetic field has a component perpendicular to at least one of the first direction and a relative sample position, wherein the relative sample position refers to a vector difference resulting from subtracting the average position of the probe spins from the sample average position. The method further comprises, while the static magnetic field is being applied to the sample region: measuring a measurand that is associated with occupations of quantum mechanical states of the probe spins. Said gradient has a magnitude, said magnitude referring to a time integral of said component of the gradient over a temporal period of the pulsed magnetic field. The method is characterized in that the magnitude is such that the measurand is increased by at least 25% over a reference measurement of the measurand, the reference measurement being performed like said measurement except for the applying of the pulsed magnetic field, wherein the pulsed magnetic field is not applied in the reference measurement.

## Description

### FIELD OF THE DISCLOSURE

The present disclosure relates to a method and an apparatus for increasing the signal associated with the exposure of localized probe spins in a solid to a magnetic field generated by precessing sample spins, in particular wherein the precessing sample spins are nuclear spins.

### BACKGROUND

Magnetic resonance techniques, which are also referred to as spin resonance techniques in the context of this disclosure, detect the behavior of precessing sample spins in a magnetic field. Magnetic resonance techniques exist in a large number of varieties, including nuclear magnetic resonance, wherein the precessing sample spins are nuclear spins, electron spin resonance, wherein the precessing sample spins are electronic spins, and proton spin resonance, wherein the precessing sample spins are proton spins.

Respective techniques are powerful tools for studying the structure and properties of materials at the atomic and molecular level. For example, nuclear magnetic resonance techniques are widely used in chemistry, biology, and medicine to determine molecular structures, identify compounds, and analyze dynamics of molecules. It is also used in medical imaging as the basis of magnetic resonance imaging, which provides detailed images of soft tissues. Electron spin resonance and proton spin resonance are used to study systems with unpaired electrons, such as free radicals, transition metals, or defects in solids. This technique provides insights into electronic structures, bonding environments, and reactions involving paramagnetic species. Both methods are non-destructive and provide critical information about molecular interactions, conformations, and dynamics in various fields, from drug design to materials science.

In any of said variations of the magnetic resonance techniques, it is important that the magnetic field in which the sample spins precess is spatially homogeneous. Said spatially homogeneous magnetic field ensures that all nuclei experience the same magnetic environment, preventing inhomogeneities that would cause different sample spins to precess at slightly different frequencies, leading to dephasing. Said dephasing results in a loss, or a reduction, respectively, of the signal being measured in the magnetic resonance technique which is being performed. This is generally undesirable. To the contrary, an enlarged signal being measured is desirable, improving the accuracy, sensitivity and statistical reliability of the measurement.

### SUMMARY OF THE DISCLOSURE

It is thus an object of this invention to provide a method and an apparatus that overcomes one or more of the disadvantages of known systems.

According to an aspect, a method is provided for increasing a measurand, said measurand being associated with the exposure of probe spins to a sample magnetic field generated by precessing sample spins. The method comprises providing a solid comprising spin systems localized therein, said spin systems providing the probe spins, said probe spins having an average position. The method comprises providing a sample in a sample region, the sample comprising said sample spins, and said sample having a sample average position. The method comprises applying a static magnetic field to the sample region, the static magnetic field having a component being spatially homogeneous in the sample region, said component acting along a first direction, said static magnetic field causing the sample spins to precess. A distance between the sample average position and the average position of the probe spins does not exceed one millimeter, such that the probe spins are exposed to a sample magnetic field generated by the precessing sample spins. The method comprises, while the static magnetic field is being applied to the sample region: applying a pulsed magnetic field to the sample region, said pulsed magnetic field having at least one component being inhomogeneous and having a gradient. The method further comprises, while the static magnetic field is being applied to the sample region: measuring a measurand that is associated with occupations of quantum mechanical states of the probe spins. Said gradient has a magnitude, said magnitude referring to a time integral of the gradient over a temporal period of the pulsed magnetic field. The method is characterized in that the magnitude is such that the measurand is increased by at least 25% over a reference measurement of the measurand, the reference measurement being performed like said measurement except for the applying of the pulsed magnetic field, wherein the pulsed magnetic field is not applied in the reference measurement.

According to another aspect, a method is provided for increasing a measurand, said measurand being associated with the exposure of probe spins to a sample magnetic field generated by precessing sample spins. The method comprises providing a solid comprising spin systems localized therein, said spin systems providing the probe spins, said probe spins having an average position. The method comprises providing a sample in a sample region, the sample comprising said sample spins, and said sample having a sample average position. The method comprises applying a static magnetic field to the sample region, the static magnetic field having a component being spatially homogeneous in the sample region, said component acting along a first direction, said static magnetic field causing the sample spins to precess. A distance between the sample average position and the average position of the probe spins does not exceed one millimeter, such that the probe spins are exposed to a sample magnetic field generated by the precessing sample spins. The method comprises, while the static magnetic field is being applied to the sample region: applying a pulsed magnetic field to the sample region, the pulsed magnetic field having a component along the first direction, wherein a gradient of said component of the pulsed magnetic field has a component perpendicular to at least one of the first direction and a relative sample position, wherein the relative sample position refers to a vector difference resulting from subtracting the average position of the probe spins from the sample average position. The method further comprises, while the static magnetic field is being applied to the sample region: measuring a measurand that is associated with occupations of quantum mechanical states of the probe spins. Said gradient has a magnitude, said magnitude referring to a time integral of said component of the gradient over a temporal period of the pulsed magnetic field. The method is characterized in that the magnitude is such that the measurand is increased by at least 25% over a reference measurement of the measurand, the reference measurement being performed like said measurement except for the applying of the pulsed magnetic field, wherein the pulsed magnetic field is not applied in the reference measurement.

A respective method, against all conventional wisdom related to magnetic resonance techniques, produces an enlarged measurand or an enlarged measured signal, respectively, using a gradient along the direction of the static magnetic field. This is a surprising effect, since, as laid above, any inhomogeneity of the static magnetic field in a magnetic resonance technique has so far been believed to cause dephasing, said dephasing reducing the measurand, or the measured signal, respectively.

In other words, while the pulsed magnetic field is being applied, the total magnetic field at the sample, resulting from the summation of the static magnetic field and the pulsed magnetic field, is inhomogeneous.

In the method according to this disclosure, the enlarged measurand is achieved making use of an indirect detection scheme for the precession of the sample spins. This indirect detection scheme uses probe spins, which are spin systems localized in a solid. The indirect detection scheme allows for enlarging the measured signal in the presence of a gradient of a magnetic field, more specifically, a gradient of the pulsed magnetic field along the first direction, i.e., along the direction of the static magnetic field.

Because of the small distance between the sample (denoted in the claim by the average position of the sample) and the probe spins, the probe spins and the precessing sample spins interact in this indirect detection scheme. Hence, as in a conventional, directly-detecting magnetic resonance technique, the measurand, which is associated with occupations of quantum mechanical states of the probe spins, reflects the behavior of the precessing sample spins.

In more detail, the method according to the disclosure does not avoid dephasing of the precession of the sample spins, but allows for - and deliberately generates - dephasing of the sample spins to enlarge the measurand. It is particularly surprising that the dephasing can result in an enlarged measurand, since, according to conventional wisdom related to magnetic resonance techniques, any dephasing gives rise to a reduced signal and measurand.

Going into even more detail, the inventors have realized that the possibility to achieve an enlarged measurement in the indirect detection scheme is associated with phase differences of the interactions of an exemplary one of the probe spins with the multiple sample spins. Depending on the relative position of any one of the sample spins with respect to said probe spin, said sample spin contributes to the measurand with a contribution having a positive or a negative signum. Since the contribution from the multiple sample spins add up to produce the measurand, they do so with according to positive or negative contributions, and thus at least in part destructively. Application of the pulsed magnetic field having the gradient according to this disclosure changes the positive and negative amplitudes, such that the contributions from the multiple sample spins add up in a more constructive way, giving an enlarged measurand.

For practical reasons, not only the single one exemplary probe spin referred to above is present in the solid. Instead, the solid typically comprises a plurality of probe spins. While, in detail, this fact may slightly complicate the described mechanism and its mathematical description, it does not impact the enlarged measurand.

According to some embodiments, the gradient of said component of the pulsed magnetic field is defined as the derivative (d/dx, d/dy, d/dz) of said component of the pulsed magnetic field. Alternatively, the gradient of said component of the pulsed magnetic field is defined as a linearized term of the derivative (d/dx, d/dy, d/dz) of said component of the pulsed magnetic field, e.g., as [(d/dx, d/dy, d/dz) of said component of the pulsed magnetic field] at the sample average position, with the x-component thereof multiplied by the distance along the x-direction from the sample average position, with the y-component thereof multiplied by the distance along the y-direction from the sample average position, and with the z-component thereof multiplied by the distance along the z-direction from the sample average position.

According to some embodiment, the pulsed magnetic field has a linear gradient. In other words, the pulsed magnetic field may be configured such that the gradient of said component of the pulsed magnetic field is homogeneous in space. Alternatively, the pulsed magnetic field may be configured such that the gradient of said component of the pulsed magnetic field varies linearly or quadratically with at least one spatial coordinate.

According to an embodiment, the magnitude of the gradient is such that a resulting dephasing of the precessing of the sample spins in said temporal period of the pulsed magnetic field is in a range from 0.05 Pi to 2 Pi, preferably in a range from 0.05 Pi to 0.5 Pi.

Using simulations, the inventors have found that a respective amount of dephasing is particularly beneficial to provide an enlarged measurand.

The dephasing may refer to a difference between a first phase angle of a first spin amongst the sample spins and a second phase angle of a second spin amongst the sample spins, in particular, wherein the second spin is the fastest-precessing spin amongst the sample spins and the second spin is the slowest-precessing spin amongst the sample spins.

Said component of the gradient may refer to a component of the gradient perpendicular to the first direction. Alternatively, said component of the gradient may refer to a component of the gradient perpendicular to both the first direction and to the relative sample position.

Using simulations, the inventors have found that a respective amount of dephasing is particularly beneficial to provide an enlarged measurand.

The sample may be arranged with respect to the static magnetic field such that a geometry factor is maximized, in particular, wherein the geometry factor G is given by G = 3 ∫[|r*B0||r-B0(B0*r)|/|r|3] d³r, wherein r is a location vector, Bo is a vector representing the static magnetic field, and the integral is carried out over the full three-dimensional space.

According to some embodiments, the magnitude of the gradient may be in a range from 15 ms*mT/m to 700 ms*mT/m or in a range from 15 ms*mT/m to 200 ms*mT/m.

Alternatively, the magnitude of the gradient may be in a range from 1.5 ms*mT/m to 70 ms*mT/m, more preferably in a range from 1.5 ms*mT/m to 20 ms*mT/m.

Using simulations, the inventors have found that such magnitudes of the gradient are particularly beneficial to provide an enlarged measurand.

The sample region maybe restricted at least in part by a surface of the solid.

Respective embodiments ensure a minimized distance between the sample spins and the probe spins, enhancing their interactions and improving the signal-to-noise ratio in the measurement.

In respective embodiments, said component of the gradient may be parallel to said surface of the solid. Alternatively, or in addition, a section of the solid may be arranged along at least part of a reference line connecting the average position of the probe spins and the sample average position.

Using simulations, the inventors have found that a respective orientation of the gradient is particularly beneficial to provide an enlarged measurand.

The surface of the solid may correspond to a crystal facet of the solid.

The surface of the solid may correspond to a high-symmetry crystal facet of the solid.

Respective high symmetry crystal facets can be produced easily and economically.

The surface of the solid may correspond to a <100>, <110> or < m> crystal facet of the solid.

The surface of the solid may correspond to a <110> or a <111> crystal facet of the solid.

On respective crystal facets, for various solids, a reference method without the pulsed magnetic field does not give any signal, or any nonzero magnitude of the measurand, respectively, for a variety of solids, and more specifically for those wherein the probe spins are orientated along the <111> crystal facet of the solid in the absence of an external magnetic field. The inventors have realized that this is a consequence of the symmetry of the localized probe spins in the solid and of the arrangement of the sample spins relative thereto. The method according to this disclosure, using the pulsed magnetic field with the gradient, brakes said symmetry, resulting in a measurand having a nonzero magnitude. In other words, the relative signal enhancement, i.e., the measurand measured using the method according to this disclosure divided by the measurand measured in a reference measurement not applying the pulsed magnetic field with the gradient, is particularly large for respective crystal facets. In yet other words, respective crystal facets, which have previously been considered unsuitable for any magnetic resonance technique, become usable applying the method according to this description.

The sample region may be in direct physical contact with the surface of the solid. Alternatively, or in addition, the sample provided in the sample region may be in direct physical contact with the surface of the solid.

The sample region or the sample provided in the sample region may be arranged symmetrically about a surface normal of said surface of the solid, in particular, arranged symmetrically with a rotational symmetry about the surface normal and/or arranged symmetrically with a mirror symmetry about a mirror plane comprising the surface normal.

The probe spins may have an orientation in the absence of an external magnetic field, wherein the first direction is parallel to said orientation.

Using simulations, the inventors have found that a respective orientation of the probe spins is particularly beneficial to provide an enlarged measurand.

In respective embodiments, the solid may be a crystalline solid, and the orientation of the probe spins in the absence of the external magnetic field may be an orientation relative to a high-symmetry crystal direction of the solid, in particular an orientation along a <111>-direction of the solid.

Using simulations, the inventors have found that a respective orientation of the probe spins is particularly beneficial to provide an enlarged measurand.

The solid may be a diamond. The spin systems localized in the solid may be provided by nitrogen-vacancy defects.

According to some embodiments, the static magnetic field is orientated along the first direction. Alternatively, or in addition, any component of the static magnetic field perpendicular to the first direction may be smaller than the component of the static magnetic field along the first direction, in particular at least by a factor of 10 or at least by a factor of 100.

According to some embodiments, the orientation of the probe spins in the absence of the external magnetic field is orientated along the first direction. Alternatively, or in addition, any component of the orientation of the probe spins in the absence of the external magnetic field perpendicular to the first direction may be smaller than the component of the orientation of the probe spins in the absence of the external magnetic field along the first direction, in particular at least by a factor of 10 or at least by a factor of 100.

According to some embodiments, the pulsed magnetic field is orientated along the first direction and/or any component of the pulsed magnetic field perpendicular to the first direction is smaller than the component of the pulsed magnetic field along the first direction, in particular at least by a factor of 10 or at least by a factor of 100.

According to some embodiments, a second direction is defined as said direction of the gradient of said component of the pulsed magnetic field perpendicular to at least one of the first direction and the relative sample position, and wherein the gradient of said component of the pulsed magnetic field is orientated along the second direction. Alternatively, or in addition, any component of the gradient of said component of the pulsed magnetic field perpendicular to the second direction may be smaller than the component of the gradient of said component of the pulsed magnetic field along the second direction, in particular at least by a factor of 10 or at least by a factor of 100.

According to some embodiments, the measurand is measured after the pulsed magnetic field is applied to the sample region and/or the measurand is measured no sooner than applying the pulsed magnetic field to the sample region.

According to some embodiments, the static magnetic field is adapted to cause the sample spins to precess around the first direction.

According to some embodiments, during a pulse duration of the pulsed magnetic field, a sign of said component of the pulsed magnetic field does not change.

According to some embodiments, during a fraction of a pulse duration of the pulsed magnetic field, said component of the pulsed magnetic field is constant within +/- 20% or within +/- 10%, in particular, wherein said fraction of the pulse duration of the pulsed magnetic field amounts to at least half of the pulse duration of the pulsed magnetic field or to at least 70% of the pulse duration of the pulsed magnetic field.

The sample spins may be nuclear spins of atomic nuclei comprised in the sample, in particular of hydrogen atomic nuclei comprised in the sample.

Using simulations, the inventors have found that the method is particularly beneficial to provide an enlarged measurement signal in the context of a respective, indirect, nuclear magnetic resonance technique.

According to some embodiments, each of the sample spins provides at least two quantum mechanical states having an energy difference from each other when the static magnetic field is applied. In respective embodiments, the method may further comprise, while the static magnetic field is being applied to the sample region: initializing the sample spins in a superposition of said at least two quantum mechanical states, and/or applying a Pi/2-pulse to the sample region, said Pi/2-pulse being a Pi/2-pulse with respect to a pair of quantum mechanical states from said at least two quantum mechanical states.

The method may further comprise, after applying the Pi/2-pulse to the sample region, applying a Pi-pulse or a series of Pi-pulses to the probe spins, in particular, wherein said Pi-pulse(s) is/are a Pi-pulse/Pi-pulse(s) with respect to the quantum mechanical states of the probe spins.

The Pi/2-pulse and the Pi-pulse or the series of Pi-pulses may form an AERIS pulse sequence or a CASR pulse sequence.

According to conventional wisdom, the detection of sample spins via probe spins in a solid is not possible using the AERIS pulse sequence. Instead, according to conventional wisdom, the symmetry of the technique dictates a zero measurand when the AERIS pulse sequence is applied. The inventors have realized that the method according to this description, by applying the pulsed magnetic field having the gradient, brakes said symmetry, resulting in a detectable measurand. Hence, the method according to this disclosure improves the flexibility of detection techniques using probe spins in a solid to derive information about precessing sample spins.

Said Pi/2-pulse may be applied to the sample region, the Pi/2-pulse having a spatially varying amplitude, said spatially varying amplitude having a gradient having a component perpendicular to the first direction.

Like the pulsed magnetic field having the gradient, a respective shape of the Pi/2-pulse can be applied to enlarge the measurand. The usage of the respective Pi/2-pulse may be performed in addition to the application of the pulsed magnetic field having the gradient to further enlarge the measurand. In alternative embodiments, the respective Pi/2-pulse is applied instead of the application of the pulsed magnetic field having the gradient, to enlarge the measurand.

The spatially varying amplitude of the Pi/2-pulse may have a gradient perpendicular to the relative sample position.

According to some embodiments, the gradient of the spatially varying amplitude of the Pi/2-pulse has a component along a third direction perpendicular to the first direction, in particular, wherein the gradient of the spatially varying amplitude is orientated along the third direction. Alternatively, or in addition any component of the gradient of the spatially varying amplitude perpendicular to the third direction may be smaller than the component of the gradient of the spatially varying amplitude along the third direction, in particular at least by a factor of 10 or at least by a factor of 100.

Using simulations, the inventors have found that the application of a respective Pi/2-pulse is particularly beneficial to provide an enlarged measurement signal.

According to some embodiments, measuring the measurand associated with the occupations of the quantum mechanical states of the probe spins comprises or is an optical measurement, in particular a photoluminescence measurement.

According to some embodiments, the method further comprises providing an optical excitation to the spin systems localized in the solid, in particular to generate an initial occupation of at least one of the quantum mechanical states of the probe spins.

Another aspect relates to an apparatus for measuring a measurand associated with the exposure of probe spins to a sample magnetic field generated by precessing sample spins. The apparatus comprises a sample holder defining a sample region for arranging a sample therein, and defining an average position of the sample region, and a solid comprising spin systems localized therein, said spin systems providing the probe spins, said probe spins having an average position. The apparatus further comprises a static-magnetic-field generator, said static-magnetic field generator adapted to apply a static magnetic field to the sample region, the static magnetic field having a component being spatially homogeneous in the sample region, said component acting along a first direction, said static magnetic field being adapted to cause sample spins comprised in a sample to precess when the sample is arranged in the sample region. A distance between the average position of the sample region and the average position of the probe spins does not exceed one millimeter. The apparatus further comprises a pulsed-magnetic-field generator, said pulsed-magnetic-field generator adapted to apply a pulsed magnetic field to the sample region, the pulsed magnetic field having a component along the first direction, wherein a gradient of said component of the pulsed magnetic field has a component perpendicular to at least one of the first direction and a relative sample position, wherein the relative sample position refers to a vector difference resulting from subtracting the average position of the probe spins from the average position of the sample region. The apparatus further comprises a measurement unit, said measurement unit adapted to measure a measurand that is associated with occupations of quantum mechanical states of the probe spins. The apparatus further comprises a controller comprising at least one processor and at least one memory, the controller adapted to control the static-magnetic-field generator, the pulsed-magnetic-field generator, and the measurement unit. The controller is adapted to control said components such that the pulsed-magnetic-field generator applies the pulsed magnetic field to the sample region while the static-magnetic field generator applies the static magnetic field to the sample region; such that the measurement unit measures the measurand while the static-magnetic field generator applies the static magnetic field to the sample region; and such that the pulsed-magnetic-field generator applies the pulsed magnetic field with said gradient having a magnitude, said magnitude referring to a time integral of said component of the gradient over a temporal period of the pulsed magnetic field, wherein the magnitude is such that the measurand is increased by at least 25% over a reference measurement of the measurand, the reference measurement being performed like said measurement except for the applying of the pulsed magnetic field, wherein the pulsed magnetic field is not applied in the reference measurement.

### LIST OF FIGURES

In the following, a detailed description of the present disclosure and examples thereof is given with reference to the figures. The figures show schematic illustrations of
Fig. 1: a method according to an embodiment of the present disclosure;
Fig. 2: an experimental setup implementing the method according to an embodiment of the present disclosure;
Fig. 3a to Fig. 5b: other experimental setups, the setup of each of the figures implementing the method according to a different embodiment of the present disclosure;
Fig. 6a: sample spins precessing in a static magnetic field in the absence of dephasing;
Fig. 6b: simulated contributions of the sample spins of Fig. 6a to the measurand;
Fig. 7a: sample spins precessing in a static magnetic field in the presence of a dephasing according to an embodiment;
Fig. 7b: simulated contributions of the sample spins of Fig. 7a to the measurand;
Fig. 8: simulated contributions of sample spins precessing in a static magnetic field in the absence of dephasing to the measurand;
Fig. 9: simulated change in the measurand when the pulsed magnetic field is applied;
Fig. 10: an apparatus adapted to perform the method; and
Fig. 11: pulse sequences according to some embodiments.

### DESCRIPTION OF EXAMPLES

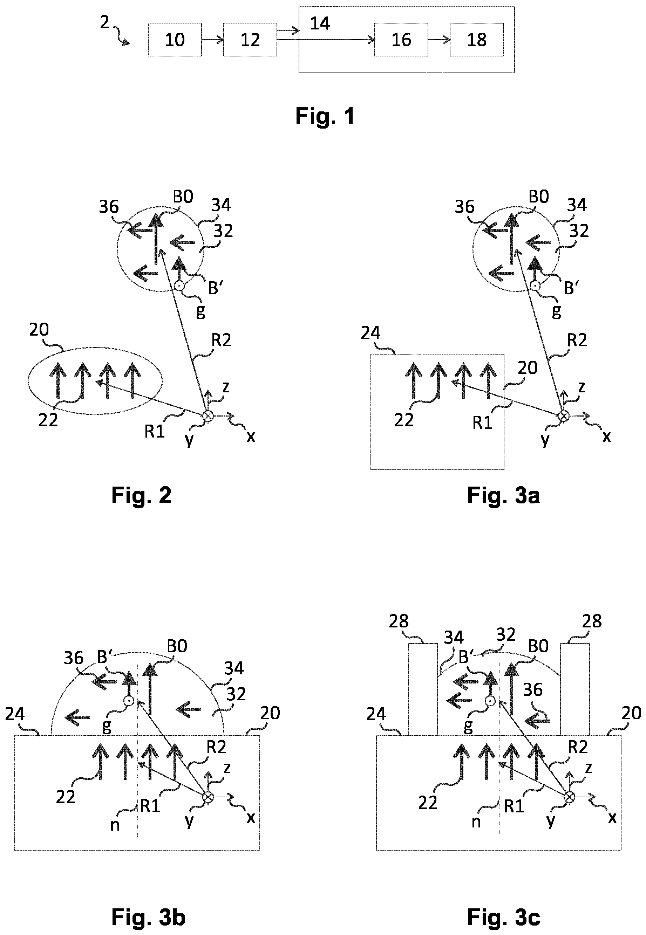

Fig. 1 illustrates a method 2 for increasing a measurand, said measurand being associated with the exposure of probe spins 22 to a sample magnetic field generated by precessing sample spins 36, according to a first embodiment.

The method 2 comprises providing 10 a solid 20 comprising spin systems 22 localized therein, said spin systems 22 providing the probe spins 22, said probe spins 22 having an average position R1.

The method 2 comprises providing 12 a sample 32 in a sample region 34, the sample 32 comprising said sample spins 36, and said sample 32 having a sample average position R2.

The method 2 comprises applying 14 a static magnetic field B to the sample region 34, the static magnetic field B having a component being spatially homogeneous in the sample region 34, said component acting along a first direction z, said static magnetic field B causing the sample spins 36 to precess.

a distance |R2 - R1| between the sample average position R2 and the average position R1 of the probe spins 22 does not exceed one millimeter, such that the probe spins 22 are exposed to a sample magnetic field generated by the precessing sample spins 36.

The method 2 comprises, while the static magnetic field B is being applied to the sample region 34: applying 16 a pulsed magnetic field B' to the sample region 34, the pulsed magnetic field B' having a component along the first direction z, wherein a gradient g of said component of the pulsed magnetic field B' has a component perpendicular to at least one of the first direction z and a relative sample position R2-R1, wherein the relative sample position R2-R1 refers to a vector difference resulting from subtracting the average position R1 of the probe spins 22 from the sample average position R2.

The method 2 further comprises, while the static magnetic field B is being applied to the sample region 34: measuring 18 a measurand that is associated with occupations of quantum mechanical states of the probe spins 22.

Said gradient g has a magnitude, said magnitude referring to a time integral of said component of the gradient g over a temporal period of the pulsed magnetic field B'.

The magnitude is such that the measurand is increased by at least 25% over a reference measurement of the measurand, the reference measurement being performed like said measurement except for the applying of the pulsed magnetic field B', wherein the pulsed magnetic field B' is not applied in the reference measurement.

Fig. 2 shows, according to an embodiment, an experimental setup implementing the method 2.

In the depicted embodiment, the solid 20 comprising spin systems 22 localized therein is a diamond with nitrogen vacancy defects localized therein, the nitrogen vacancy defects providing the localized spin systems 22. According to alternative embodiments (not shown), the localized spin systems are provided by silicon carbide (SiC) divacancies, nitrogen-related defects in SiC, phosphorus donor centers in silicon (Si), bismuth donor centers in silicon (Si), quantum dots in gallium arsenide (GaAs), rare-earth ions in yttrium orthosilicate (Y2SiO5), color centers in 4H- and 6H-SiC, fluorine vacancies in magnesium oxide (MgO), fluorine vacancies in calcium fluoride (CaF2), chromium or manganese ions which are available in various hosts.

The solid 20 is arranged at a position R1.

The position R1 refers to the average position of the localized spin systems 22.

The method is applicable to a large variety of samples 32.

In the depicted embodiment, the sample spins 36 comprised in the sample 32 are nuclear spins. A respective embodiment of the method may also be referred to as a nuclear magnetic resonance (NMR) method. In the depicted embodiment, the sample spins 36 are provided by hydrogen nuclei. According to various alternative embodiments, the sample spins 36 are provided by ¹H, ²H (deuterium), ³He, ¹³C, ¹⁴N, ¹⁵N, ¹⁷O, ¹⁹F, ²¹Ne, ²³Na, ²⁵Mg, ²⁹Si, ³¹P, ³³S, ³⁵Cl, ³⁷Cl, ³⁹R, ⁴⁰K, ⁴³Ca, ⁴⁵Sc, ⁴⁹Ti, ⁵⁰V, ⁵¹V, ⁵³Cr, ⁵⁵Mn, ⁵⁷Fe, ⁵⁹Co, ⁶¹Ni, ⁶³Cu, ⁶⁵Cu, ⁶⁷Zn, ⁶⁹Ga, ⁷¹Ga, ⁷³Ge, ⁷⁵As, ⁷⁷Se, ⁷⁹Br, ⁸¹Br, ⁸³Kr, ⁸⁵Rb, ⁸⁷Rb, ⁸⁹Y, ⁹¹Zr, ⁹³Nb, ⁹³Mo, ⁹⁹Ru, ¹⁰¹Ru, ¹⁰³Rh, ¹¹³Cd, ¹¹⁵In, ¹¹⁹Sn, ¹²¹Sb, ¹²³Sb, ¹²⁷I, ¹²⁹Xe, ¹³¹Xe, ¹³³Cs, ¹³⁹La, ¹⁴¹Pr, ¹⁴³Nd, ¹⁴⁵Nd, ¹⁴⁷Sm, ¹⁴⁹Sm, ¹⁵¹Eu, ¹⁵³Eu, ¹⁵⁷Gd, ¹⁵⁹Tb, ¹⁶¹Dy, ¹⁶³Dy, ¹⁶⁵Ho, ¹⁶⁷Er, ¹⁶⁹Tm, ¹⁷¹Yb, ¹⁷³Yb, or ¹⁷⁵Lu. According to yet other embodiments, the sample spins 36 are electronic spins. A respective embodiment of the method may also be referred to as electron spin resonance (ESR) method. According to yet other embodiments, the sample spins 36 are proton spins. A respective embodiment of the method may also be referred to as proton spin resonance (ESR) method.

The sample 32 is arranged at the position R2. More specifically, the position R2 refers to the center of mass of the sample 32.

In the depicted embodiment, the sample region 34 is confined along all three spatial directions. According to an alternative embodiment, the sample region 34 is a half-space, in particular a half-space limited by the solid 20. According to an alternative embodiment, the sample region is cylindrical or has the shape of a channel, for example constrained by a sample holder as common in biology and in particular in microbiology. According to an alternative embodiment, the sample region 34 has the shape of a layer or a quasi-two-dimensional film.

In preferred embodiments, the sample region 34 is constrained by a sample holder and or by the solid 20. In respective embodiments, the sample region 34 defines the average position R2 for the sample.

A static magnetic field B0 is applied to the sample 32, or in the sample region 34, respectively.

The static magnetic field Bo is ideally homogeneous, i.e., having both a spatially homogeneous amplitude and a spatially homogeneous direction in the sample region 34, or across the sample 32, respectively.

In Fig. 2, a coordinate system is depicted. The coordinate system does not add any physical structure to the experimental setup, but serves as a reference frame.

The coordinate system is orientated such that its z axis is along the static magnetic field Bo. In other words, the static magnetic field Bo can be described as |B0|*e_{z}, wherein e_{z} is a unit vector pointing along the z axis and | Bo | is, within the limits of technical feasibility, a constant.

Preferably, the solid 20 is orientated such that the spin systems 22 localized in the solid 20 are oriented along the direction of the static magnetic field Bo, or along the z axis, respectively.

The static magnetic field Bo causes the sample spins 36 to precess around the direction of the static magnetic field Bo, or in the horizontal x-y plane, respectively.

While the static magnetic field Bo is applied, a pulsed magnetic field B' is applied to the sample 32, or in the sample region 34, respectively.

Preferably, the pulsed magnetic field B' is orientated along the static magnetic field Bo, or along the z axis, respectively. In other words, the pulsed magnetic field B' can be described as |B'|*e_{z}, wherein e_{z} is a unit vector pointing along the z axis.

In contrast to the static magnetic field Bo, which has a spatially homogeneous amplitude |B0| in the sample region 34, or across the sample 32, respectively, the amplitude |B'| of the pulsed magnetic field B' varies spatially in the sample region 34, or across the sample 32, respectively.

In other words, the amplitude |B'| can be written as an amplitude |B'| (x, y, z), wherein x, y, z are the directions with respect to the depicted coordinate system, and |B'| (x, y, z) having a non-constant dependency on said directions x, y, z. For the sake of brevity, the component of the pulsed magnetic field B' along the direction of the static magnetic field Bo, which is identical to the amplitude of the pulsed magnetic field B' in the depicted embodiment, will be referred to as |B'| in the following (rather than |B'| (x, y, z)).

Fig. 2 shows the gradient g of the component |B'| of the pulsed magnetic field B', wherein g = Δ|B'|, Δ denoting the gradient function (d/dx, d/dy, d/dz).

The inventors have realized that such a gradient g, i.e., a gradient of the pulsed magnetic field B' as described above, can be applied to enlarge the measured signal obtained using an experimental setup such as the experimental setup depicted in Fig. 2.

In detail, the described pulsed magnetic field B' is constructed to allow for enlarging a measurand measured with the setup depicted in Fig. 2.

Nevertheless, in |B'| needs to be fine-adjusted for this purpose. In other words, B' needs to be applied with |B'| having a suitable (x, y, z) dependence for the pulsed magnetic field B' to enlarge the measured signal. If |B'|, and hence the pulsed magnetic field B', is not applied accordingly, but with an undesirable shape, the application of the pulsed magnetic field B' does not enlarge the measured signal or may even reduce the measured signal.

The inventors have performed comprehensive simulations to determine a suitable |B'| to achieve signal enlargement. From those comprehensive simulations, in combination with analytical considerations, the following algorithm has been identified to determine the shape of B' for achieving a signal enlargement:

The pulsed magnetic field B', and more specifically its amplitude |B'|, is to be selected such that the magnitude of the gradient is such that the measurand is increased by at least 25% over a reference measurement of the measurand. Therein, the reference measurement is performed like the measurement according to this description, except for the applying of the pulsed magnetic field. The pulsed magnetic field B' is not applied in the reference measurement.

|B'| should be shaped such that the gradient thereof, g = Δ|B'|, is perpendicular to the direction z of the static magnetic field Bo or perpendicular to the relative sample position R2-R1, said relative sample position R2-R1 be defined as the vector difference resulting from subtracting the average position R1 of the probe spins 22 from the sample average position R2.

This limits the shape of |B'|, by requiring that g = Δ|B'| lies either in a plane perpendicular to Bo, or in a plane perpendicular to R2-R1. For each of said planes, this leaves two remaining degrees of freedom: the azimuthal angle within said plane (i.e., around a reference direction being perpendicular to the plane), and the amplitude, i.e., a prefactor for |B'|.

The person skilled in the art is easily able to select suitable parameters for those degrees of freedom to achieve signal enlargement.

According to an embodiment, the increase of the measurand can be determined experimentally, by adjusting a pulsed-magnetic-field generator while static-magnetic-field generator provides the static magnetic field. In some embodiments, a static-magnetic-field generator taking the form of at least one coil this used for this purpose, and a pulsed-magnetic-field generator is used comprising shim coils. In respective embodiments, the current through the shim coils is varied and the measurand is measured while the static magnetic field is continuously applied, taking into account the boundary conditions to the static magnetic field Bo and to the pulsed magnetic field as laid out in this disclosure. The method is finished when the enlargement of the measurand is detected.

According to an alternative, preferred embodiment, said variation of the pulsed magnetic field B' and the measurement of the measurand while the static magnetic field Bo is being applied is performed in a simulation. The simulation determines the measurand as an output of the simulation, taking into account the boundary conditions to the static magnetic field Bo and to the pulsed magnetic field as laid out in this disclosure. The method is finished when the enlargement of the measurand is detected.

In respective embodiments, the simulations are performed as described in detail in F. Bruckmaier et al. "Geometry dependence of micron-scale NMR signals on NV-diamond chips," Journal of Magnetic Resonance Open 8-9 (2021) 100023. This document is enclosed herein in its entirety by reference. For a given shape and position of the sample 32 and a given distribution of the probe spins 36, a parameter sweep regarding the abovedescribed remaining two degrees of freedom can be performed.

In other words, using such simulations, the enlarged measurand can be positively verified, namely, whenever a suitable |B'| is plugged into the simulation to achieve a signal enlargement. The respective procedure, being given by the above-mentioned simulations, gives the person skilled in the art sufficient instructions to determine a suitable |B'| to achieve signal enlargement.

From the comprehensive simulations performed by the inventors, several embodiments have been identified, which the inventors hypothesize to be beneficial for achieving a signal enlargement.

According to an embodiment, |B'| refers to a component of the gradient g perpendicular to the z-direction.

According to an embodiment, |B'| refers to a component of the gradient g perpendicular to the z-direction and to the relative sample position R2-R1.

To characterize the amplitude of the pulsed magnetic field B' in further detail, a magnitude M of the gradient g is defined as the time integral of said the component of the gradient along either of the directions described above over a temporal period of the pulsed magnetic field B': M = ∫ g*e_d dt, wherein the integral is performed over a temporal period of the pulsed magnetic field, and wherein e_d is a unit vector along the selected one of the directions described above (i.e., perpendicular to the static magnetic field Bo, or perpendicular to the relative sample position R2-R2, or perpendicular to both the static magnetic field Bo and to the relative sample position R2-R2).

The magnitude M is defined using the integral over a temporal period of the pulsed magnetic field, since this integral quantity determines the dephasing of the sample spins 36. For example, providing a gradient g (or a pulsed magnetic field B' or |B'|) with a duration of 5 ms and a gradient of 2 mT/m generates the same amount of dephasing as providing a gradient g (or a pulsed magnetic field B' or |B'|) with a duration of 10 ms and a gradient of 1 mT/m. This is rooted in the fact that the gradient determines the velocity at which the sample spins 36 dephase, and the pulse duration determines for how long they do so. Dephasing the sample spins 36 for twice as much time, but at half the velocity, results in the same overall dephasing as dephasing the sample spins 36 for a single amount of time, but at the full velocity.

The absolute value of the dephasing across the sample 32 does not only depend on the gradient g, or on the pulsed magnetic field B', respectively, but also on the composition of the sample 32. This is described in a factor y, which depends on the specific sample 32.

According to some embodiments, the magnitude of the gradient g is selected such that a resulting dephasing of the precessing of the sample spins 36 in said temporal period of the pulsed magnetic field B' is in a range from 0.05 Pi to 2 Pi, preferably in a range from 0.05 Pi to 0.5 Pi. The simulations performed by the inventors indicate that a respective magnitude of the gradient is particularly beneficial to achieve signal enlargement.

According to an embodiment, the sample is arranged with respect to the static magnetic field such that a geometry factor G, as given in detail above, is maximized.

Fig. 3a schematically illustrates a setup implementing the method 2 according to an embodiment.

The setup of Fig. 3a is similar to the setup described above. Similar components are indicated with identical reference numerals. For the sake of brevity, they will not be described again, but reference is made to the corresponding detailed description above. The following description focuses on the modifications introduced in the embodiment of Fig. 3a.

The solid 20 of the embodiment of Fig. 3a has a surface 24.

According to some embodiments, the surface 24 is a high-symmetry crystal facet of the solid 20 being a crystalline solid 20. This applies, for example, to embodiments which use diamond as the solid 20, and nitrogen vacancies to provide the probe spins 22. In respective embodiments, the probe spins 22 are orientated along a <111> direction with respect to the cubic lattice of the diamond.

Here and in the following, all indicated directions refer to the cubic crystallographic system.

As can be seen from Fig. 3a the probe spins 22 are orientated along the surface normal of the surface 24 of the solid 20. For embodiments which use diamond as the solid 20, and nitrogen vacancies to provide the probe spins 22, Fig. 3a thus depicts a surface 24 being a < m>-high-symmetry crystal facet of the diamond.

In various embodiments of magnetic resonance techniques using probe spins 22 provided by nitrogen vacancies in a diamond, the sample 32 is arranged in direct contact or directly above the diamond 20. A respective embodiment is described in more detail in the following in the context of Fig. 3b.

Fig. 3b schematically illustrates a setup implementing the method 2 according to an embodiment.

The setup of Fig. 3b is similar to the setup described above. Similar components are indicated with identical reference numerals. For the sake of brevity, they will not be described again, but reference is made to the corresponding detailed description above. The following description focuses on the modifications introduced in the embodiment of Fig. 3b.

In the embodiment of Fig. 3b, the sample 32 is arranged in direct contact with the diamond 20 providing an exemplary solid 20. In other words, the sample region 34 is constrained by the diamond 20, or its surface 24, respectively.

In conventional techniques, which do not apply the pulsed magnetic field B', no signal can be measured using the arrangement depicted in Fig. 3b, for the symmetry reasons known from the prior art and explain in detail in F. Bruckmaier et al. "Geometry dependence of micron-scale NMR signals on NV-diamond chips," Journal of Magnetic Resonance Open 8-9 (2021) 100023.

Surprisingly, the application of the pulsed magnetic field B' as described above in the context of the foregoing embodiments breaks the respective symmetry and gives rise to an enlarged, measurable signal.

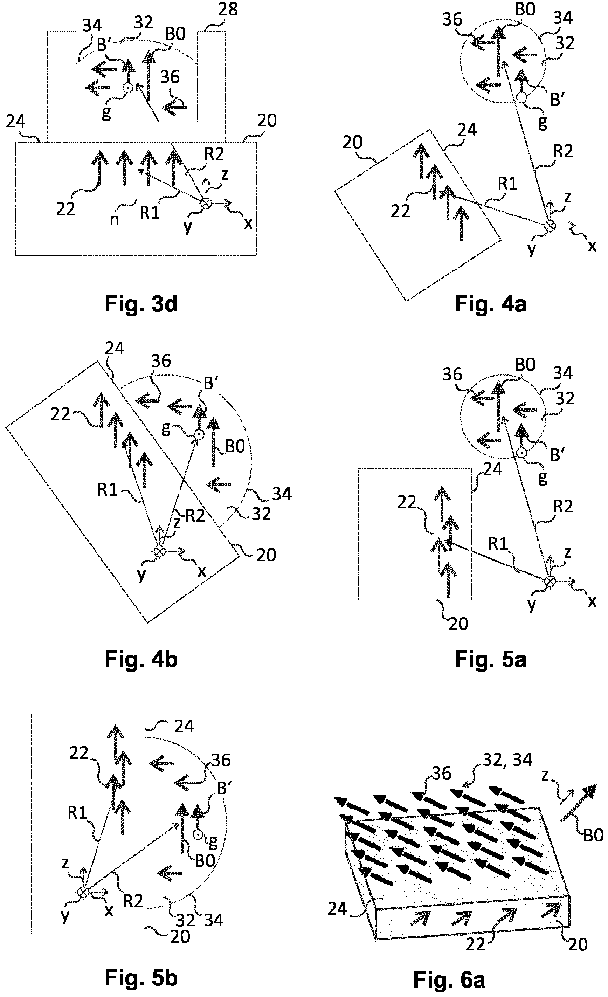

Similar considerations apply to the embodiments depicted in Fig. 3c, Fig. 3d, wherein the sample region 34 is only in part confined by the diamond 20, or its surface 24, respectively, and in part by a sample holder 28 made from a material different from the diamond 20.

Producing the sample holder 28 from a material different from the diamond gives further flexibility and control over the shape of the sample region 34. This is, because a different material, such as a polymer, can be used for the sample holder 28, giving an improved flexibility in the shaping and machining thereof.

Similar as for the embodiment of Fig. 3b, in conventional techniques, which do not apply the pulsed magnetic field B', no signal could be measured using the arrangement depicted in Fig. 3c, Fig. 3d.

Surprisingly, the application of the pulsed magnetic field B' as described above in the context of the foregoing embodiments breaks the respective symmetry and gives rise to an enlarged, measurable signal.

In any of the embodiments of Fig. 3b to Fig. 3d, the sample 32 is arranged symmetrically about the surface normal n of the surface 24. In conventional techniques, the signal suppression, i.e., the absence of a detectable signal, is particularly pronounced for such a symmetric arrangement.

More specifically, the surface normal n of the surface 24 refers to the surface normal of the surface 24 through the average position R1 of the probe spins 22.

The sample 32 of the embodiment of Fig. 3b has both a rotational symmetry about the surface normal n of the surface 24, and a mirror symmetry, namely about a plurality mirror planes comprising the surface normal of the surface 24. In the embodiment of Fig. 3b, any plane comprising the surface normal of the surface 24 forms a respective mirror plane.

The sample 32 of the embodiment of Fig. 3c, Fig. 3d has a mirror symmetry about a mirror plane comprising the surface normal of the surface 24.

In the embodiment of Fig. 3c, Fig. 3d, a first respective mirror plane (y-z plane) is perpendicular to the plane of the respective figure.

In the embodiment of Fig. 3c, Fig. 3d, a second respective mirror plane (x-z-plane) is given by the plane of the respective figure.

The application of the pulsed magnetic field B' as described above in the context of the foregoing embodiments beneficially gives an enhanced, detectable signal even in setups with a respective symmetrically of the sample 32 about the surface normal n.

Fig. 4a schematically illustrates a setup implementing the method 2 according to an embodiment.

The setup of Fig. 4a is similar to the setup described in the context of the embodiment of Fig. 3a. Similar components are indicated with identical reference numerals. For the sake of brevity, they will not be described again, but reference is made to the corresponding detailed description above. The following description focuses on the modifications introduced in the embodiment of Fig. 4a.

As opposed to the solid 20 of the embodiment of Fig. 3a, the solid 20 comprises a surface 24 with an orientation having an angle towards the orientation of the probe spins 22.

Respective embodiments are particularly beneficial when the solid 20 is a diamond 20, and the probe spins 22 are provided by nitrogen vacancy defects 22 therein.

In respective embodiments, the surface orientation depicted in Fig. 4a corresponds to a <001>-high-symmetry crystal facet of the diamond. A respective surface of the diamond 20 can be fabricated with good surface quality using established techniques.

Fig. 4b schematically illustrates a setup implementing the method 2 according to an embodiment.

The setup of Fig. 4b is similar to the setup described in the context of the embodiment of Fig. 3b. Similar components are indicated with identical reference numerals. For the sake of brevity, they will not be described again, but reference is made to the corresponding detailed description above. The following description focuses on the modifications introduced in the embodiment of Fig. 4b.

As in the embodiment of Fig. 4a, the surface orientation depicted in Fig. 4a corresponds to a <001>-high-symmetry crystal facet of a diamond 20.

For the arrangement depicted in Fig. 4b, a detectable measurand is expected even in conventional methods, which do not apply the pulsed magnetic field B'.

Simulations performed by the inventors have demonstrated, that the pulsed magnetic field B' as described above can also be advantageously applied to the arrangement depicted in Fig. 4b. Sad simulations have demonstrated that the measured signal is enlarged by up to 40% when the pulsed magnetic field B' as described above is applied.

Fig. 6a illustrates the precision of sample spins 36 of a sample 32 arranged above a diamond 20 with nitrogen vacancies defects 22 therein, when a static magnetic field Bo is applied.

In Fig. 6a, the pulsed magnetic field B' is not applied.

Consequently, the sample spins 36 precess in phase, without any dephasing.

The surface 24 depicted in Fig. 6a is a <001>-high-symmetry crystal facet 24 of a diamond 20 with nitrogen vacancies defects providing the probe spins 22.

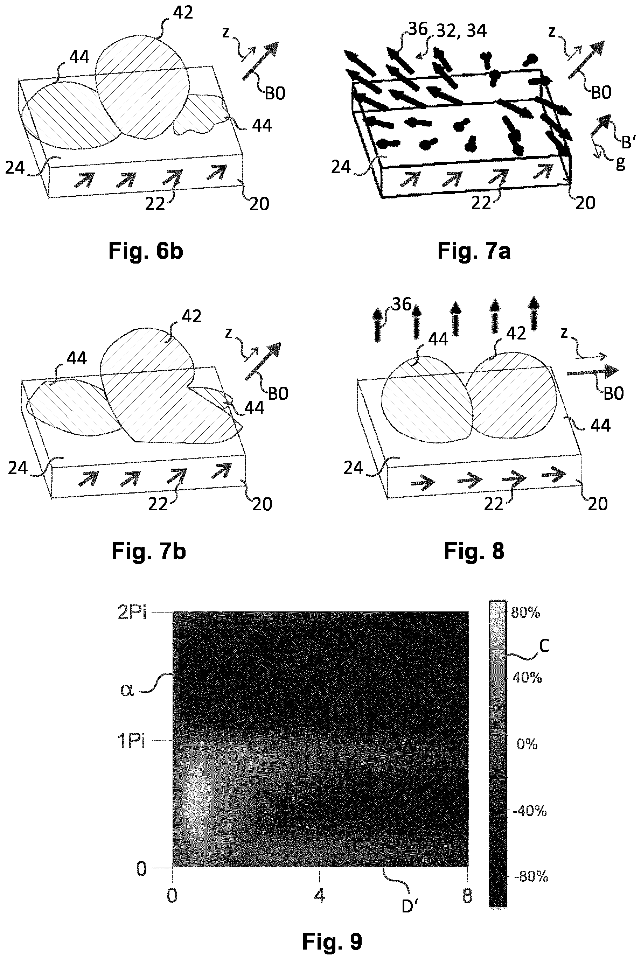

Fig. 6b shows the simulated contributions 42, 44 of the different regions of the sample 32 to the measurand.

The contributions 42 to the measurand are positive. The contributions 44 to the measurand are negative.

As the simulation depicted in Fig. 6b demonstrates, different regions of the sample contribute with different signums (positive or negative) to the measurand. The measurand is determined by the sum of the positive contributions 42 and the negative contributions 44.

Fig. 7a illustrates the precision of sample spins 36 of a sample 32 arranged above a diamond 20 with nitrogen vacancy defects 22 therein, when a static magnetic field Bo is applied. The situation is generally similar to the one depicted in Fig. 6a.

However, as opposed to Fig. 6a, in Fig. 7a, the pulsed magnetic field B' is applied.

Consequently, the sample spins 36 precess at different angular velocities, resulting in differences between their phase angles. In the context of this disclosure, the respective difference between the phase angles is referred to as the dephasing. More specifically, the dephasing refers to the largest difference between the phase angles of two sample spins 36 occurring in the sample 32. In other words, the dephasing refers to the difference between a first phase angle of a first spin amongst the sample spins 36 and a second phase angle of a second spin amongst the sample spins 36, wherein the second spin is the fastest-precessing spin amongst the sample spins 36 and the second spin is the slowest-precessing spin amongst the sample spins 36.

In Fig. 7b the simulated contributions 42, 44 of the different regions of the sample 32 to the measurand is schematically illustrated, similar to Fig. 6b. However, the simulation results shown in Fig. 7b refer to the situation illustrated in Fig. 7a, i.e., with the pulsed magnetic field B' being applied.

As Fig. 7b demonstrates, the positive contributions 42 to the measurand are increased and the negative contributions 44 to the measurand are decreased as compared to the situation of Fig. 6a, Fig. 6b without the pulsed magnetic field B' being applied.

In other words, the measurand is enlarged for the arrangement depicted in Fig. 6a, Fig. 7a when the pulsed magnetic field B' is being applied. The enlargement amounts to about 40%.

The inventors have realized that a dephasing in the range from 0.05 Pi to 2 Pi, preferably in a range from 0.05 Pi to 0.5 Pi, is preferable to achieve signal enlargement. The inventors hypothesize that a respective magnitude of the dephasing is beneficial not only in the arrangement depicted in Fig. 6a, Fig. 7a, but for many more embodiments as well.

Fig. 8 illustrates the precision of sample spins 36 of a sample 32 arranged above a diamond 20 with nitrogen vacancy defects 22 therein, when a static magnetic field Bo is applied.

In Fig. 8, the pulsed magnetic field B' is not applied.

The arrangement depicted in Fig. 8 is generally similar to the arrangement depicted in Fig. 6a.

As opposed to the arrangement depicted in Fig. 6a, in Fig. 8 the surface 24 of the diamond 20 is a <011>-high-symmetry crystal facet of the diamond 20.

As laid out above, in conventional techniques, which do not apply the pulsed magnetic field B', no signal can be measured using the arrangement depicted in Fig. 8.

This is confirmed by the depicted results of the simulations, demonstrating that the positive contributions 42 to the measurand and the negative contributions 44 to the measurand are identical in amplitude but having opposite signums, so that they cancel out, resulting in a measurand amounting to o.

Simulations (not shown) show that, when the pulsed magnetic field B' is applied to the arrangement depicted in Fig. 8, the positive contributions 42 are increased and the negative contributions 44 are reduced, such that a detectable measurand emerges. In other words, the measurand is enlarged. Simulations indicate that the enlargement may amount to approximately a factor of four. In yet other words, the <011>-high-symmetry crystal facet of the diamond 20, which was not considered suitable for magnetic resonance techniques, becomes suitable for this purpose when the method according to the description is applied.

Fig. 9 gives a 2D-plot showing the enlargement of the measurand as a greyscale plot, as obtained from simulations.

The plot depicts on the vertical axis an angle α, referring to the angle between the direction of the gradient g between the x-axis and the y-axis. In Fig. 9a, an angle α of o corresponds to a gradient g having an orientation parallel to the x-axis, and an angle of pi/2 corresponds to a gradient g having an orientation parallel to the y-axis, respectively.

The plot depicts on the horizontal axis an alternative representation D' of the dephasing, i.e., alternative to the representation in terms of phase angles. The alternative representation D' gives the dephasing in terms of 0.1*S*y, wherein 0.1 is a number (1 tenth), S is the sample size (in µm, for example along the direction |R2-R1| or in terms of an average sample size averaged over all three spatial directions x, y, z), and gamma is a sample-dependent constant, also referred to as the gyro magnetic ratio of the sample spins.

Bright sections in the 2D-plot show experimental conditions under which the measurand is enlarged.

More specifically, the 2D-plot of Fig. 9 gives the relative change C of the measurand in the situation with the pulsed magnetic field B' applied as compared to the reference measurement, wherein the pulsed magnetic field B' is not applied. The change is indicated quantitatively by the greyscale bar in the right part of Fig. 9. For example, a relative change C of 40% indicates an enhancement of the measurand by 40% when the pulsed magnetic field B' is applied as compared to the reference measurement wherein the pulsed magnetic field B' is not applied.

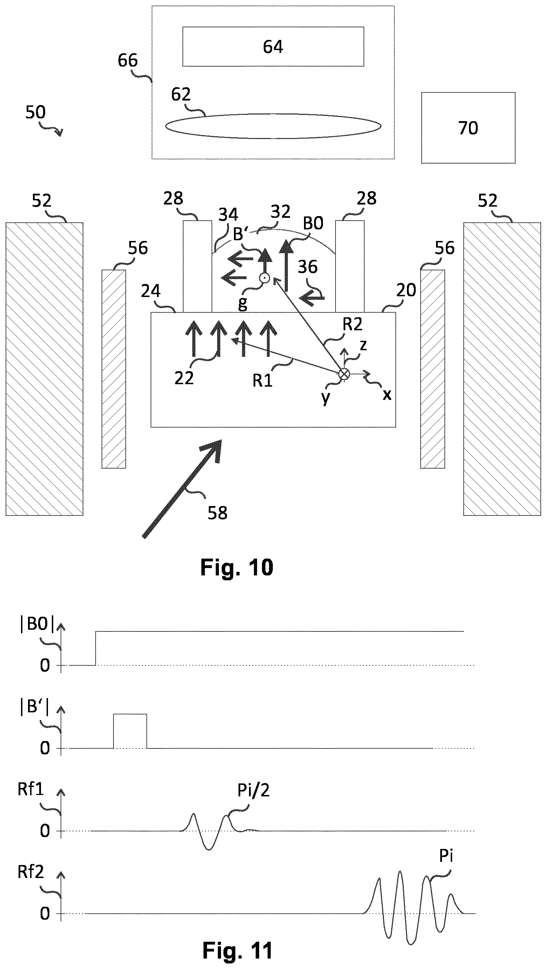

Fig. 10 schematically illustrates an apparatus 50 for performing the method 2.

The apparatus 50 comprises a sample holder 28 defining the sample region 34 for arranging a sample 32 therein, the position of the sample holder 28 defining the average position of the sample region 34.

The apparatus 50 further comprises the solid 20 according to any of the embodiments described above.

The apparatus 50 further comprises a static-magnetic-field generator 52 adapted to generate the static magnetic field Bo as described in the context of any of the embodiments above.

In the depicted embodiment, the static-magnetic-field generator 52 comprises a pair of Helmholtz coils.

The apparatus 50 further comprises a pulsed-magnetic-field generator 56.

In the depicted embodiment, the pulsed-magnetic-field generator 56 comprises at least one coil arranged inside of the static-magnetic-field generator 52. According to some embodiments, the pulsed-magnetic-field generator 56 further comprises an electrical waveform generator to drive the generation of the pulsed magnetic field B'.

In alternative embodiments (not shown), the static-magnetic-field generator 52 comprises a Halbach magnet, and the pulsed-magnetic-field generator 56 comprises a ferrofluid arranged an inner volume defined by the Halbach magnet. The ferrofluid distorts the homogeneous static magnetic field Bo generated by the static-magnetic-field generator 52 to generate the gradient g.

The apparatus 50 is further provided with a measurement unit 66, said measurement unit 66 adapted to measure a measurand that is associated with occupations of quantum mechanical states of the probe spins 22.

A controller 70 comprising at least one processor and at least one memory (not shown) controls the static-magnetic-field generator 52, the pulsed-magnetic-field generator 56, and the measurement unit 66 to perform the method 2 according to any of the embodiments described above.

In a preferred embodiment, the solid 20 is a diamond 20, and the probe spins 22 localized therein are provided by nitrogen vacancy defects of the diamond 20.

In said embodiments, a laser beam 58 is provided to the probe spins 22 to generate an initial occupation of quantum-mechanical states associated with the probe spins 22.

In the depicted embodiment, the measurand is the power or intensity of photoluminescence light emitted from the solid 20. In such embodiments, the measurement unit 66 comprises a focusing lens 62 to collect the photoluminescence light emitted from the solid 20 and a photodiode 64 to detected the photoluminescence light.

The examples of the present disclosure disclosed herein only constitute specific examples for illustration purposes. The present invention can be implemented in various ways and with many modifications without altering the underlying basic properties. Therefore, the present invention is only defined by the claims as stated below.

Fig. 11 illustrates an exemplary pulse sequence.

At the beginning of the method, the static magnetic field Bo is switched on.

With the static magnetic field Bo is switched on, the pulsed magnetic field B' is applied.

Optionally, as depicted by Rf1, the sample spins 36 are initializing in a superposition of their at least two quantum mechanical states. In other word, Rf1 indicates an electromagnetic wave (radio frequency or microwave frequency) applied to the sample 32, or to the sample region 34, respectively. For the initialization, in some embodiments, a Pi/2-pulse is applied to the sample region 34, said Pi/2-pulse being a Pi/2-pulse with respect to a pair of quantum mechanical states from said at least two quantum mechanical states.

Optionally, as depicted by Rf2, an electromagnetic wave (radio frequency or microwave frequency) is applied to the probe spins 22. More specifically, in some embodiments, a Pi-pulse or a sequence of Pi-pulses is applied to the probe spins 22, said Pi-pulses being Pi-pulses with respect to the quantum mechanical states of the probe spins 22.

In some embodiments, the initiating Pi/2-pulse applied to the sample 32, or to the sample region 34, respectively, and the Pi-pulse or the sequence of Pi-pulses applied to the probe spins 22 are configured such that they implement an AERIS pulse sequence or a CASR pulse sequence.

## Claims

1. A method (2) for increasing a measurand, said measurand being associated with the exposure of probe spins (22) to a sample magnetic field generated by precessing sample spins (36), the method (2) comprising:
providing (10) a solid (20) comprising spin systems (22) localized therein, said spin systems (22) providing the probe spins (22), said probe spins (22) having an average position (R1);
providing (12) a sample (32) in a sample region (34), the sample (32) comprising said sample spins (36), and said sample (32) having a sample average position (R2);
applying (14) a static magnetic field (B) to the sample region (34), the static magnetic field (B) having a component being spatially homogeneous in the sample region (34), said component acting along a first direction (z), said static magnetic field (B) causing the sample spins (36) to precess;
wherein a distance (|R2 - R1|) between the sample average position (R2) and the average position (R1) of the probe spins (22) does not exceed one millimeter, such that the probe spins (22) are exposed to a sample magnetic field generated by the precessing sample spins (36); and
while the static magnetic field (B) is being applied to the sample region (34):
applying (16) a pulsed magnetic field (B') to the sample region (34), the pulsed magnetic field (B') having a component along the first direction (z), wherein a gradient (g) of said component of the pulsed magnetic field (B') has a component perpendicular to at least one of the first direction (z) and a relative sample position (R2-R1), wherein the relative sample position (R2-R1) refers to a vector difference resulting from subtracting the average position (R1) of the probe spins (22) from the sample average position (R2);
measuring (18) a measurand that is associated with occupations of quantum mechanical states of the probe spins (22);
said gradient (g) has a magnitude, said magnitude referring to a time integral of said component of the gradient (g) over a temporal period of the pulsed magnetic field (B'),
**characterized in that**:
the magnitude being such that the measurand is increased by at least 25% over a reference measurement of the measurand, the reference measurement being performed like said measurement except for the applying of the pulsed magnetic field (B'), wherein the pulsed magnetic field (B') is not applied in the reference measurement.

2. The method (2) according to claim 1, wherein the magnitude of the gradient (g) is such that a resulting dephasing of the precessing of the sample spins (36) in said temporal period of the pulsed magnetic field (B') is in a range from 0.05 Pi to 2 Pi, preferably in a range from 0.05 Pi to 0.5 Pi,
in particular, wherein the dephasing refers to a difference between a first phase angle of a first spin amongst the sample spins (36) and a second phase angle of a second spin amongst the sample spins (36), in particular, wherein the second spin is the fastest-precessing spin amongst the sample spins (36) and the second spin is the slowest-precessing spin amongst the sample spins (36).

3. The method (2) according to claim 1 or 2,
wherein said component of the gradient (g) refers to a component of the gradient perpendicular to the first direction (z), or
wherein said component of the gradient (g) refers to a component of the gradient perpendicular to both the first direction (z) and to the relative sample position (R2-R1).

4. The method (2) according to any of the preceding claims, wherein the magnitude of the gradient (g) is in a range from 1.5 ms*mT/m to 70 ms*mT/m, more preferably in a range from 1.5 ms*mT/m to 20 ms*mT/m.

5. The method (2) according to any of the preceding claims, wherein the sample region (34) is restricted at least in part by a surface of the solid (20),
in particular,
wherein said component of the gradient (g) is parallel to said surface of the solid (20); and/or
wherein a section of the solid (20) is arranged along at least part of a reference line connecting the average position (R1) of the probe spins (22) and the sample average position (R2).

6. The method (2) according to claim 5, wherein the surface of the solid (20) corresponds to a crystal facet of the solid (20),
in particular, to a high-symmetry crystal facet,
in particular, to a <100>, <110> or <111> crystal facet,
in particular, to a <110> or a <111> crystal facet.

7. The method (2) according to claim 5 or 6,
wherein the sample region (34) or the sample (32) provided in the sample region (34) is in direct physical contact with the surface of the solid (20); and/or
wherein the sample region (34) or the sample (32) provided in the sample region (34) is arranged symmetrically about a surface normal of said surface of the solid (20), in particular, arranged symmetrically with a rotational symmetry about the surface normal and/or arranged symmetrically with a mirror symmetry about a mirror plane comprising the surface normal.

8. The method (2) according to any of the preceding claims,
wherein the probe spins (22) have an orientation in the absence of an external magnetic field, wherein the first direction (z) is parallel to said orientation;
in particular, wherein the solid (20) is a crystalline solid (20), and wherein the orientation of the probe spins (22) in the absence of the external magnetic field is an orientation relative to a high-symmetry crystal direction of the solid (20), in particular an orientation along a <111>-direction of the solid (20).

9. The method (2) according to any of the preceding claims, wherein the solid (20) is a diamond and the spin systems (22) localized therein are provided by nitrogen-vacancy defects.

10. The method (2) according to any of the preceding claims,
wherein the static magnetic field (B) is orientated along the first direction (z) and/or wherein any component of the static magnetic field (B) perpendicular to the first direction (z) is smaller than the component of the static magnetic field (B) along the first direction (z), in particular at least by a factor of 10 or at least by a factor of 100; and/or
wherein the pulsed magnetic field (B') is orientated along the first direction (z) and/or wherein any component of the pulsed magnetic field (B') perpendicular to the first direction (z) is smaller than the component of the pulsed magnetic field (B') along the first direction (z), in particular at least by a factor of 10 or at least by a factor of 100; and/or
wherein a second direction is defined as said direction of the gradient (g) of said component of the pulsed magnetic field (B') perpendicular to at least one of the first direction (z) and the relative sample position (R2-R1), and wherein the gradient (g) of said component of the pulsed magnetic field (B') is orientated along the second direction and/or wherein any component of the gradient (g) of said component of the pulsed magnetic field (B') perpendicular to the second direction is smaller than the component of the gradient (g) of said component of the pulsed magnetic field (B') along the second direction, in particular at least by a factor of 10 or at least by a factor of 100; and/or
the measurand is measured after the pulsed magnetic field (B') is applied to the sample region (34) and/or the measurand is measured no sooner than applying the pulsed magnetic field (B') to the sample region (34); and/or
wherein the static magnetic field (B) is adapted to cause the sample spins (36) to precess around the first direction (z); and/or
wherein, during a pulse duration of the pulsed magnetic field (B'), a sign of said component of the pulsed magnetic field (B') does not change; and/or
wherein, during a fraction of a pulse duration of the pulsed magnetic field (B'), said component of the pulsed magnetic field (B') is constant within +/- 20% or within +/- 10%, in particular, wherein said fraction of the pulse duration of the pulsed magnetic field (B') amounts to at least half of the pulse duration of the pulsed magnetic field (B') or to at least 70% of the pulse duration of the pulsed magnetic field (B').

11. The method (2) according to any of the preceding claims, wherein the sample spins (36) are nuclear spins of atomic nuclei comprised in the sample (32), in particular of hydrogen atomic nuclei comprised in the sample (32).

12. The method (2) according to any of the preceding claims, wherein each of the sample spins (36) provides at least two quantum mechanical states having an energy difference from each other when the static magnetic field (B) is applied, and wherein the method (2) further comprises, while the static magnetic field (B) is being applied to the sample region (34):
initializing the sample spins (36) in a superposition of said at least two quantum mechanical states, and/or applying a Pi/2-pulse to the sample region (34), said Pi/2-pulse being a Pi/2-pulse with respect to a pair of quantum mechanical states from said at least two quantum mechanical states;
in particular:
wherein the method (2) further comprises, after applying the Pi/2-pulse to the sample region (34), applying a Pi-pulse or a series of Pi-pulses to the probe spins (22), in particular, wherein said Pi-pulse(s) is/are a Pi-pulse/Pi-pulses with respect to the quantum mechanical states of the probe spins (22);
in particular, wherein the Pi/2-pulse and the Pi-pulse or the series of Pi-pulses form an AERIS pulse sequence or a CASR pulse sequence.

13. The method (2) according to claim 12, wherein said Pi/2-pulse is applied to the sample region (34), the Pi/2-pulse having a spatially varying amplitude, said spatially varying amplitude having a gradient (g) having a component perpendicular to the first direction (z);
in particular:
wherein the spatially varying amplitude has a gradient (g) perpendicular to the relative sample position (R2-R1); and/or
wherein the gradient (g) of the spatially varying amplitude has a component along a third direction perpendicular to the first direction (z), in particular, wherein the gradient (g) of the spatially varying amplitude is orientated along the third direction and/or wherein any component of the gradient (g) of the spatially varying amplitude perpendicular to the third direction is smaller than the component of the gradient (g) of the spatially varying amplitude along the third direction, in particular at least by a factor of 10 or at least by a factor of 100.

14. The method (2) according to any of the preceding claims,
wherein measuring the measurand associated with the occupations of the quantum mechanical states of the probe spins (22) comprises or is an optical measurement, in particular a photoluminescence measurement; and/or
wherein the method (2) further comprises providing an optical excitation to the spin systems (22) localized in the solid (20), in particular to generate or enlarge the occupations of the quantum mechanical states of the probe spins (22).

15. An apparatus (50) for measuring a measurand associated with the exposure of probe spins (22) to a sample magnetic field generated by precessing sample spins (36), the apparatus (50) comprising:
a sample holder defining a sample region (34) for arranging a sample therein, and defining an average position of the sample region (34);
a solid (20) comprising spin systems (22) localized therein, said spin systems (22) providing the probe spins (22), said probe spins (22) having an average position;
a static-magnetic-field generator (52), said static-magnetic field generator (52) adapted to apply a static magnetic field (B) to the sample region (34), the static magnetic field (B) having a component being spatially homogeneous in the sample region (34), said component acting along a first direction (z), said static magnetic field (B) being adapted to cause sample spins (36) comprised in a sample (32) to precess when the sample (32) is arranged in the sample region (34);
wherein a distance (|R2 - R1|) between the average position of the sample region (34) and the average position of the probe spins (22) does not exceed one millimeter;
a pulsed-magnetic-field generator (56), said pulsed-magnetic-field generator (56) adapted to apply a pulsed magnetic field (B') to the sample region (34), the pulsed magnetic field (B') having a component along the first direction (z), wherein a gradient (g) of said component of the pulsed magnetic field (B') has a component perpendicular to at least one of the first direction (z) and a relative sample position (R2-R1), wherein the relative sample position (R2-R1) refers to a vector difference resulting from subtracting the average position (R1) of the probe spins (22) from the average position (R1) of the sample region (34);
a measurement unit (66), said measurement unit (66) adapted to measure a measurand that is associated with occupations of quantum mechanical states of the probe spins (22); and
a controller (70) comprising at least one processor and at least one memory, the controller (70) adapted to control the static-magnetic-field generator (52), the pulsed-magnetic-field generator (56), and the measurement unit (66), such that:
the pulsed-magnetic-field generator (56) applies the pulsed magnetic field (B') to the sample region (34) while the static-magnetic field generator (52) applies the static magnetic field (B) to the sample region (34);
the measurement unit (66) measures the measurand while the static-magnetic field generator applies the static magnetic field (B) to the sample region (34); and
the pulsed-magnetic-field generator (56) applies the pulsed magnetic field (B') with said gradient (g) having a magnitude, said magnitude referring to a time integral of said component of the gradient (g) over a temporal period of the pulsed magnetic field (B'), wherein the magnitude is such that the measurand is increased by at least 25% over a reference measurement of the measurand, the reference measurement being performed like said measurement except for the applying of the pulsed magnetic field (B'), wherein the pulsed magnetic field (B') is not applied in the reference measurement.
